(19) Europäisches Patentamt
European Patent Office
Office européen des brevets

(11) EP 1 768 472 A2

(12) EUROPEAN PATENT APPLICATION

(43) Date of publication:
28.03.2007 Bulletin 2007/13

(51) Int Cl.:
H05K 1/14 (2006.01)

(21) Application number: 06119552.5

(22) Date of filing: 25.08.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 24.09.2005 KR 20050089049

(71) Applicant: Samsung Electronics Co., Ltd.
Suwon-si, Gyeonggi-Do (KR)

(72) Inventors:
• Lim, Han-Sang
Samsung Electronics Co., Ltd.
Gyeonggi-do (KR)

• Park, Dong-Ik
Samsung Electronics Co., Ltd.
Gyeonggi-do (KR)
• Kisselev, Boris
Samsung Electronics Co., Ltd.
Gyeonggi-do (KR)

(74) Representative: Zimmer, Franz-Josef
Grünecker, Kinkeldey,
Stockmair & Schwanhäusser
Anwaltssozietät
Maximilianstrasse 58
80538 München (DE)

(54) **Connection structure between plurality of boards of portable terminal**

(57) Provided is a connection structure between a plurality of boards of a portable terminal. The boards are connected by a signal cable including a plurality of signal lines and a power source cable including a plurality of power source lines and the remaining portions of the power source lines, except for connector connection portions, are connected to form plane conducting lines.

FIG.3

## Description

The present invention generally relates to a connection structure between a plurality of boards of a portable terminal, and in particular, to a connection structure in which stable power supply can be achieved by connecting the remaining portions of a plurality of power source lines connected in parallel between the boards, except for connector connection portions, to form a single plane conducting line.

Generally, portable terminals keep pace with high sensitivity, miniaturization, and lightness of electronic parts. Bar-type cellular phones as first-generation cellular phones and flip-type cellular phones as second-generation cellular phones were commonly used. At present, flip-type cellular phones and folder-type cellular phones as third-generation cellular phones are widely used.

Wearable phones worn on clothes or a body part such as watch-type cellular phones worn on a user's wrist are being developed.

Korean patent application No. 2005-41508, assigned to the assignee of the present application, discloses a portable terminal including a plurality of boards to improve the portability of a wearable phone.

As illustrated in FIG. 1, the portable terminal disclosed in Korean patent application No. 2005-41508 includes a plurality of boards 10, in each of which various parts are mounted. A plurality of connectors 11 are mounted between the boards 10 and connection lines 20 are included to electrically connect the connectors 11.

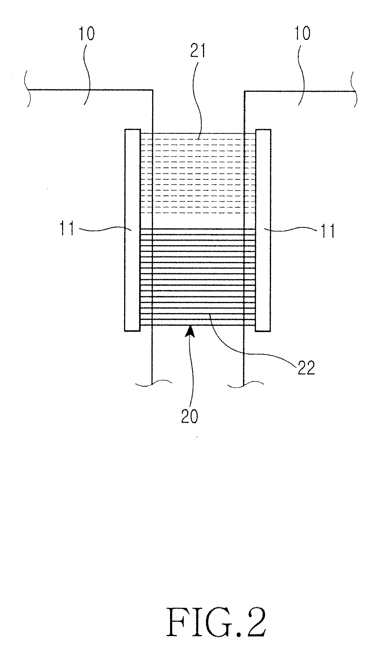

As illustrated in FIG. 2, the connection lines 20 between the connectors 11 include signal lines 21 for transmitting various communication signals and signals for controlling various parts and power source lines 22 for power supply.

The number of signal lines 21 and power source lines 22 provided in the connection lines 20 is closely related to the size of each of the boards 10. The size of each of the boards 10 is closely related to the appearance of a wearable phone. In other words, as the size of each of the boards 10 decreases, the appearance of the wearable phone is improved, but the number of boards 10 increases, the number of connections between the boards 10 also increases.

The increase in the number of connections between the boards 10 leads to an increase in the length of power source lines. Since the thickness of the power source lines is limited due to the connections between the boards 10, both the inductance and AC resistance component of the power source lines increase in the wearable phone, unlike in a general portable terminal.

In other words, since all parts exist in a single substrate in a general portable terminal, parasitic components of a power source structure such as inductance or AC resistance can be reduced by using wide power source lines or minimizing the length of power source lines. However, in a portable terminal including a plurality of boards, parasitic components of power source lines increase for the reason described above, resulting in unstable power supply to a device and causing a large voltage drop.

Such problems also occur in a ground structure, and thus a connection structure between a power source and a ground, which has low inductance and AC resistance, is required to ensure the performance of a portable terminal having a plurality of boards.

It is, therefore, the object of the present invention to provide a connection structure between a plurality of boards of a portable terminal, in which stable power supply can be achieved by connecting the remaining portions of a plurality of power source lines connected in parallel between the boards, except for connector connection portions, to form a single plane conducting line.

This object is solved by the subject matter of the independent claims.

Preferred embodiments are defined in the dependent claims.

It is an aspect of the present invention to provide a connection structure between a plurality of boards of a portable terminal, in which a stable ground can be maintained by arranging a plurality of ground lines at predetermined intervals to secure a large ground plane conducting line.

According to one aspect of the present invention, there is provided a connection structure between a plurality of boards of a portable terminal. The boards are connected by a signal cable including a plurality of signal lines and a power source cable including a plurality of power source lines and the remaining portions of the power source lines, except for connector connection portions, are connected to form plane conducting lines.

The present invention will become more apparent from the following detailed description when taken in conjunction with the accompanying drawings in which:

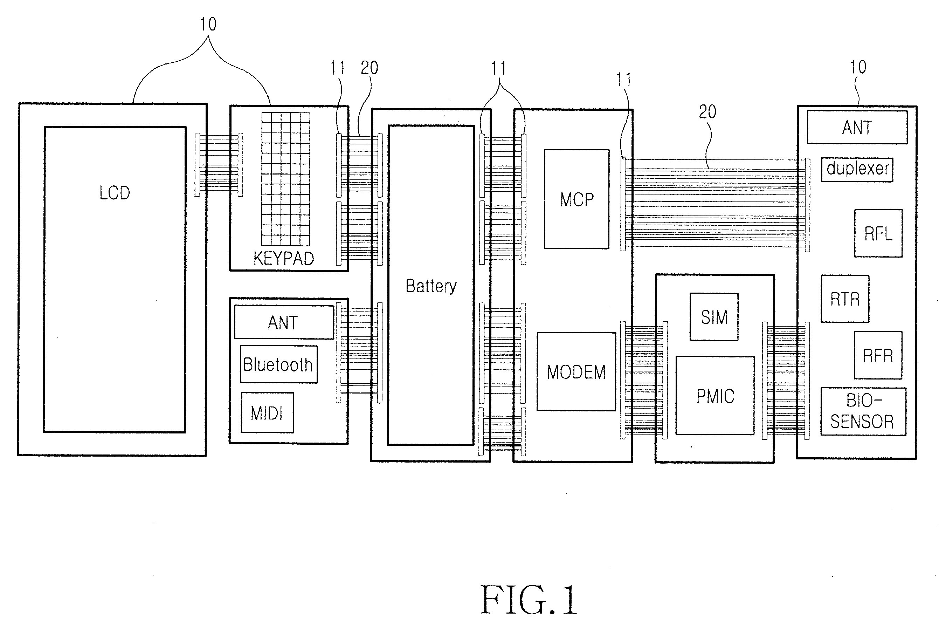

FIG. 1 illustrates a portable terminal including a plurality of boards according to the prior art;
FIG. 2 illustrates a connection structure between boards according to the prior art; and
FIG. 3 illustrates a connection structure between boards according to an embodiment of the present invention.

A preferred embodiment of the present invention will now be described in detail with reference to the annexed drawings.

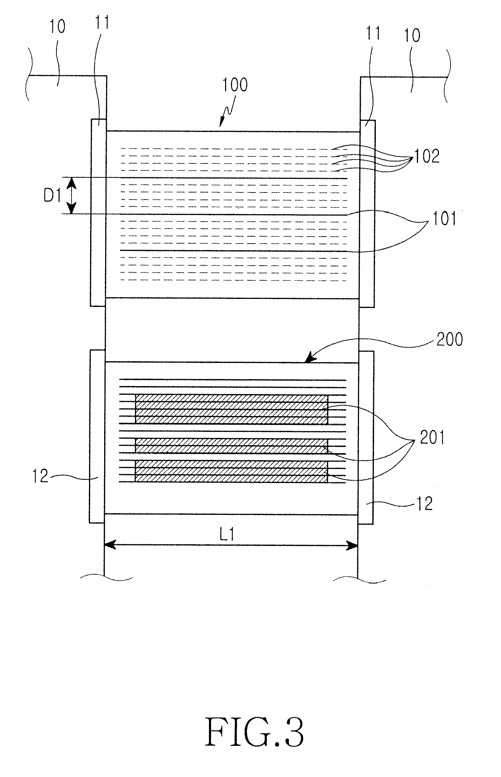

FIG. 3 illustrates a connection structure between boards according to the present invention.

As illustrated in FIG. 3, a signal connector 11 and a power source connector 12 are mounted at the edge of each of a plurality of boards 10. The signal connectors 11 are connected by a signal cable 100 and the power source connectors 12 are connected by a power source cable 200. The signal cable 100 includes a plurality of signal lines 102 for transmitting various communication signals and signals for controlling various parts.

The power source cable 200 includes a plurality of power source lines 201 for supplying power to various parts.

While the signal connectors 11 and the power source connectors 12 are separately mounted and are connected by the signal cable 100 and the power source cable 200 independently of each other in an embodiment of the present invention, either the signal connectors 11 or the power source connectors 12 may be connected by a corresponding cable and signal lines and power source lines may be independently arranged within the cable.

Since the connection lines of the signal cable 100 and the power source cable 200 have small widths and thicknesses in accordance with the specification of the signal connector 11 and the power source connector 12, their inductance and AC resistance increase.

The power source lines 201 having large inductance and AC resistance may not provide stable power to a device during a high-speed operation, or a large voltage drop may occur. In other words, when the inductance of the power source line 201 is L, a voltage drop $V_L$ caused by the inductance L is L(di/dt). Since a change di/dt in a supply current required for the high-speed operation is large, a voltage actually supplied to a device undergoes large fluctuation.

To prevent these problems, a plurality of power source lines having a large di/dt in the power source cable 200 is arranged in parallel adjacent to one another and the remaining portions except for connector connection portions are connected. In other words, the remaining portions of the power source lines except for connector connection portions are connected to form a single plane conducting line, instead of simply connecting the power source lines in parallel.

The number of power source lines to be connected is determined by an operation speed, an operating current used, and a power source characteristic. As an operation speed increases, an operating current increases. As a result, the number of required power source lines also increases.

For example, in FIG. 3, five power source lines, three power source lines, and four power source lines of the power cable 200 are connected, respectively, thereby forming three plane conducting lines. As such, by connecting the remaining portions of a plurality of power source lines except for connector connection portions, inductance and resistance can be reduced, thereby achieving stable power supply during a high-speed operation.

Like the power source connection, a ground connection should have low inductance to guarantee a stable operation. In a high-speed circuit, a lumped circuit condition cannot be satisfied. As a result, a ground cannot be implemented through one or two connections. In other words, in order for the ground to perform shielding through stable current sync and guard trace, a plurality of ground lines 101 is used and at least one ground line 101 is arranged at predetermined intervals D1, instead of simply connecting the ground lines 101 in parallel.

For example, in FIG. 3, the ground lines 101 are arranged at predetermined intervals D1 between the signal lines 102 in the signal cable 100, i.e., each ground line is arranged for every four signal lines 102.

As such, unlike the power source lines 201, the ground lines 101 are not arranged successively, but are arranged at predetermined intervals.

The interval D1 between the ground lines 101 is determined according to a maximum frequency operating in the boards 10. A length L1 of a cable between the boards 10 is determined according to the maximum frequency. Here, the maximum frequency ranges from 800MHz to 2.1 GHz according to a supported band.

When it is assumed that the maximum frequency is f, the speed of electrons in the air is c1, and the speed of electrons in a cable is c2, the interval D1 and the length L1 are designed such that D1 ≤ c1 (kf) and L1 ≤ c2(kf). k is 20 if a conservative condition is applied and is 12 if a general condition is applied.

When the ground line 101 is arranged between the signal lines 102, at least one ground line 101 may be arranged and the interval D1 between the ground lines 101 is smaller than the calculated value. The interval D1 is not necessarily constant.

Such arrangement of the ground lines 101 can also be applied to the power source cable 200 as well as the signal cable 100. In other words, when the ground lines 101 are arranged in the power source cable 200, at least one ground line 101 may be arranged between plane conducting lines.

While a connection structure between boards of a portable terminal according to the present invention has been shown and described with reference to a certain preferred embodiment thereof, it will be understood by those skilled in the art that various changes in form and details may be made therein without departing from the scope of the invention.

## Claims

1. A connection structure between a plurality of boards of a portable terminal comprising plane conducting lines,
   wherein the boards are connected by a signal cable including a plurality of signal lines and a power source cable including a plurality of power source lines, and remaining portions of the power source lines, except for connector connection portions, are connected to form the plane conducting lines.

2. The connection structure of claim 1, wherein at least one ground line is arranged at a predetermined interval D1 between the plurality of signal lines.

3. The connection structure of claim 2, wherein the predetermined interval D1 is defined as

$$D1 \leq c1 \, (kf)$$

where c1 denotes speed of electrons in the air, f denotes a maximum frequency, and k denotes a constant.

4. The connection structure of one of claims 1 to 3, wherein several plane conducting lines including different numbers of power source lines exist in the plurality of power source lines.

5. The connection structure of claim 4, wherein the number of power source lines forming each of the plane conducting lines is determined by an operation speed, an operating current, and a power source characteristic of a device.

6. The connection structure of claim 4, wherein at least one ground line is arranged between the plane conducting lines.

7. The connection structure of one of claims 1 to 6, wherein a length L1 of the signal cable or the power source cable connecting the boards is defined as

$$L1 \leq c2 \, (kf)$$

where c2 denotes speed of electrons in a cable, f denotes a maximum frequency, and k denotes a constant.

8. The connection structure of claim 3 or 7, wherein the constant k is 20 if a conservative condition is applied and is 12 if a general condition is applied.

9. A connection structure between a plurality of boards of a portable terminal comprising plane conducting lines,
wherein remaining portions of power source lines connecting the boards in parallel, except for connector connection portions, are connected to form the plane conducting lines.

10. The connection structure of claim 9, wherein several plane conducting lines including different numbers of power source lines exist in the plurality of power source lines.

11. The connection structure of claim 10, wherein the number of power source lines forming each of the plane conducting lines is determined by an operation speed, an operating current, and a power source characteristic of a device.

12. The connection structure of claim 10, wherein at least one ground line is arranged between the plane conducting lines.

13. A connection structure between a plurality of boards of a portable terminal, comprising a plurality of signal lines,
wherein at least one ground line is arranged at a predetermined interval D1 between the plurality of signal lines connecting the boards in parallel.

14. The connection structure of claim 13, wherein the predetermined interval D1 is defined as

$$D1 \leq c1 \, (kf)$$

where c1 denotes speed of electrons in the air, f denotes a maximum frequency, and k denotes a constant.

15. The connection structure of claim 14, wherein the constant k is 20 if a conservative condition is applied and is 12 if a general condition is applied.

FIG.1

FIG.2

FIG.3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 200541508